# EUROPEAN PATENT APPLICATION

(11) **EP 4 682 949 A2**
(43) Date of publication of application: **21.01.2026**
(21) Application number: 25174442.1
(22) Date of filing: 06.05.2025
(51) Int. Cl.: H01L 21/768

(54) **PLANARIZATION METHOD FOR BACK-END-OF-LINE REGION OF INTEGRATED CIRCUIT DEVICE**

(30) Priority: 29.05.2024 US 202463652760 P; 14.11.2024 US 202418947228
(71) Applicant: Samsung Electronics Co., Ltd., Suwon-si, Gyeonggi-do 16677 (KR)
(72) Inventor: OH, Joongsuk, San Jose, CA, 95134 (US); KIM, Byounghoon, San Jose, CA, 95134 (US); CHOI, Jaemyung, San Jose, CA, 95134 (US); KIM, Johnsoo, San Jose, CA, 95134 (US); SEO, Kang-ill, San Jose, CA, 95134 (US)
(74) Representative: Kuhnen & Wacker Patent- und Rechtsanwaltsbüro PartG mbB

(57) **Abstract**

Methods of forming a back-end-of-line, BEOL, region of an integrated circuit, IC, device are provided. A method of forming a BEOL region of an IC device includes forming a metal layer on a lower via. The method includes forming a photo key (522) in an upper portion of the metal layer. The method includes forming (524) an insulating material on the photo key. Moreover, the method includes planarizing (526, 528) the insulating material and the metal layer that includes the photo key.

## Description

### TECHNICAL FIELD

The present disclosure generally relates to the field of integrated circuit (IC) devices and, more particularly, to IC devices having metal lines in a back-end-of-line (BEOL) region thereof, and to methods of fabricating such IC devices.

### BACKGROUND OF THE INVENTION

A BEOL region of an IC device may include multiple vertical levels of metal interconnects. The metal interconnects, which may also be referred to herein as metal "lines" or "wires," may provide routes for electrical signals to travel across a semiconductor chip, thereby connecting various components (e.g., transistors) of the IC device. The BEOL region may also include insulating layers that separate different layers of the metal interconnects, and vias that vertically extend into the insulating layers to electrically connect the metal interconnects. The arrangement of metal interconnects and vias may facilitate efficient signal routing and allow for complex interconnect patterns within the IC device.

### SUMMARY OF THE INVENTION

A method of forming a BEOL region of an IC device, according to some embodiments herein, may include forming a metal layer on a lower via. The method may include forming a photo key in an upper portion of the metal layer. The method may include forming an insulating material on the photo key. Moreover, the method may include planarizing the insulating material and the metal layer that includes the photo key.

A method of forming a BEOL region of an IC device, according to some embodiments herein, may include forming a metal layer on a lower via. The method may include forming a photo key in an upper portion of the metal layer. The method may include forming an insulating material on the photo key. The method may include selectively planarizing the insulating material. Moreover, the method may include non-selectively planarizing the insulating material, after selectively planarizing the insulating material. Selectively planarizing may comprise performing a selective chemical-mechanical planarization, CMP, that selectively removes the insulating material, and non-selectively planarizing may comprise performing a non-selective dry etch, NSE, of the insulating material and the metal layer, after performing the selective CMP. The BEOL region may comprise a crack-stop wall structure comprising a via-layer portion and a metal-line-layer portion on the via-layer portion, the metal-line-layer portion comprising a first portion having a lower surface that is not in contact with the via-layer portion and a second portion that is in contact with the via-layer portion, the second portion having an oxide material in a recess therein.

A method of forming a BEOL region of an IC device, according to some embodiments herein, may include forming a metal layer on a lower via layer. The method may include forming a photo key in an upper portion of the metal layer. The method may include forming an insulating material on the photo key. Moreover, the method may include reducing a height of the insulating material and the photo key. The insulating material may be in the photo key after reducing the height of the insulating material and the photo key. Reducing the height of the insulating material and the photo key may comprise: performing a selective chemical-mechanical planarization, CMP, that selectively removes the insulating material; and performing a non-selective dry etch, NSE, of the insulating material and the upper portion of the metal layer, after performing the selective CMP.

### BRIEF DESCRIPTION OF THE DRAWINGS

FIG. 1A is a schematic block diagram of an IC device according to some embodiments herein.
FIG. 1B is an example cross-sectional view of the BEOL region of the IC device of FIG. 1A.
FIG. 2 is another example cross-sectional view of the BEOL region of FIG. 1A.
FIGs. 3A-3C and 4A-4C are cross-sectional views illustrating operations of forming a BEOL region according to some embodiments herein.
FIG. 5 is a flowchart corresponding to the operations shown in FIGs. 3A-3C and 4A-4C.

### DETAILED DESCRIPTION

Pursuant to embodiments herein, a planarization method is provided for a BEOL region of an IC device. The planarization method includes forming an insulating material on a metal layer and then planarizing the insulating material and the metal layer. For example, the insulating material may be formed on a photo key that is formed in the metal layer. A portion of the insulating material may remain in the photo key after performing the planarization method, and can help to control a shape of the metal layer. As a result, the insulating material and the metal layer can be planarized with good local topology, and sublayer information can be read relatively easily in a surface (e.g., an upper surface) of the metal layer. In some embodiments, the planarization method may include a selective etch (e.g., selective chemical-mechanical planarization (CMP)) that is followed by a non-selective dry etch (NSE), where the combination of selective and non-selective etches can help to reduce how much of the metal layer is lost during the planarization method.

Moreover, a crack-stop wall structure in the BEOL region may include a via-layer portion and a metal-line-layer portion on the via-layer portion. The metal-line-layer portion may include (i) a first portion having a lower surface that is not in contact with the via-layer portion and (ii) a second portion having a lower surface that is in contact with the via-layer portion and an upper surface having an insulating (e.g., oxide) material thereon. The metal-line-layer portion may thus be wider than (e.g., about twice as wide as) the via-layer portion. Due to a wide and high step height of the crack-stop wall structure, the insulating material may remain on the second portion of the metal-line-layer portion of the crack-stop wall structure after planarization. A metal via that is on the crack-stop wall structure may thus be in contact with the first portion of the metal-line-layer portion and not the second portion of the metal-line-layer portion.

A semi-damascene interconnect process is a technique that may be used in the manufacture of IC devices to create metal interconnects in a BEOL region. The semi-damascene interconnect process may include, for example, depositing metal into trenches or grooves on/in a semiconductor substrate (i.e., a semiconductor wafer). In some embodiments, ruthenium (Ru) may be used as the metal for deposition in the semi-damascene interconnect process, as Ru may have low resistivity and good adhesion to dielectric materials.

According to some embodiments, in a semi-damascene interconnect scheme using Ru, a lower via may be patterned intaglio (e.g., etched into a wafer) and then filled with Ru that is deposited onto the wafer (i.e., deposited onto a substrate). The Ru layer may have a thickness that varies from one portion thereof to another, due to a design/shape of the lower via. It may be helpful to reduce this thickness variation before patterning the Ru layer. For example, before the Ru layer is patterned by subtraction, a CMP process may be performed as a planarization method for buffing the Ru layer and reducing the thickness variation. The CMP process, however, may lead to a large amount of Ru loss because it is a partial process for step height reduction instead of a stopping process. The more variation in the thickness of the Ru layer, the more CMP that may be needed, which may lead to increased Ru loss. This may make it difficult to achieve uniform thickness of the Ru layer across the whole wafer.

Ru deposition on a surface of the wafer may include depositing, for example, tens of nanometers (nm) of Ru, which may make it difficult to read sublayer photo-key information (e.g., patterns or features in the underlying layers of a photoresist during lithography) with high accuracy. Ru patterning may be beneficial for small-pitch interconnects, but difficulties related to reading the sublayer photo-key information may present challenges for lithography of small-pitch interconnects. Though a photo-key open mask may be used to mitigate these difficulties, the mask may not be cost-efficient for use in mass production.

Example embodiments herein may provide photo-key design and planarization methods in an Ru semi-damascene process for IC devices. In some embodiments, the photo key (e.g., photoresist pattern in the lower via layer) of a via layer may be embossed or drawn, and the photo key (in the upper via layer including, for example, Ru) may be filled with an insulating material and planarized with good local topology. According to some embodiments, the planarization methods include both a CMP process on the insulating material and an NSE. The amount/degree of the CMP/NSE may be controlled to ensure the insulating material remains inside the photo key (in the upper via layer) while being removed from other areas. Accordingly, difficulties related to reading the sublayer photo-key information (e.g., owing to the deposition of Ru) may be mitigated.

Example embodiments will be described in greater detail with reference to the attached figures.

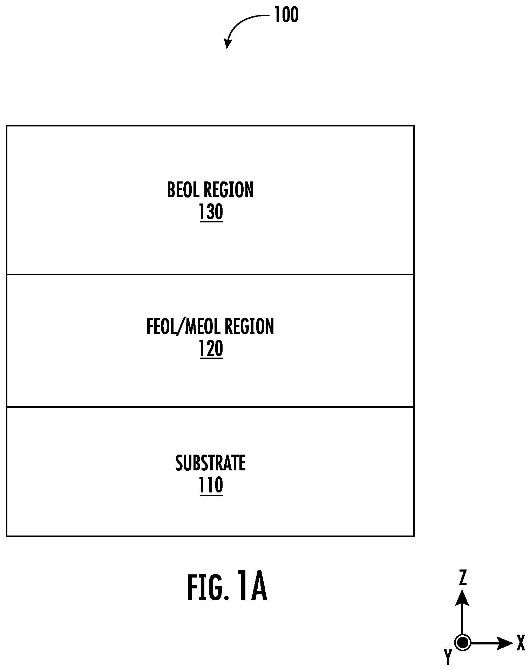

FIG. 1A is a schematic block diagram of an IC device 100 according to some embodiments. The device 100 may be, for example, a semiconductor memory device for storing data and/or a semiconductor logic device for processing data. The device 100 may include a substrate (e.g., a semiconductor substrate) 110, a BEOL region 130 that is on the substrate 110, and a front-end-of-line (FEOL) and/or middle-end-of-line (MEOL) region 120 that is between (in a vertical direction Z) the BEOL region 130 and the substrate 110. As an example, the FEOL/MEOL region 120 may include devices such as transistors, capacitors, and/or resistors. Moreover, the BEOL region 130 may include interconnect wires, vias, and dielectric structures.

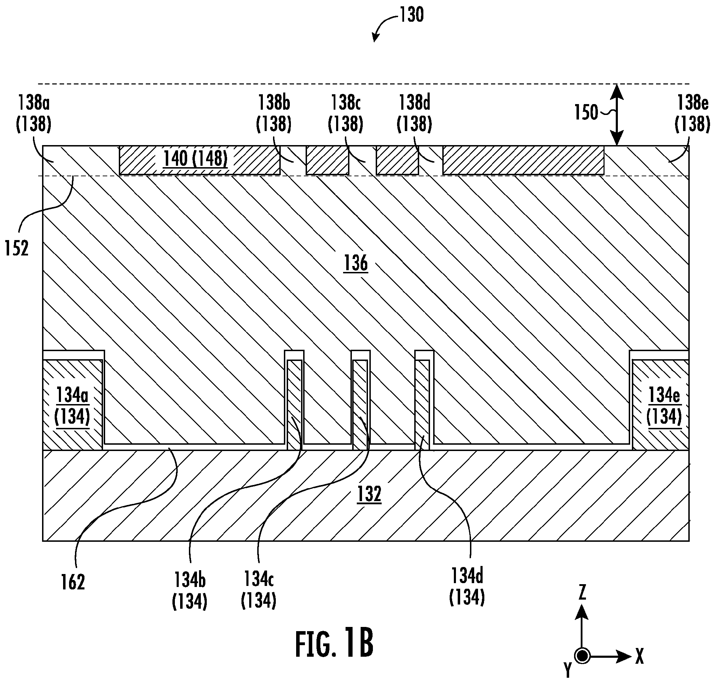

FIG. 1B is an example cross-sectional view of the BEOL region 130 of FIG. 1A. The BEOL region 130 comprises a plurality of BEOL elements, including various metal lines (e.g., metal/interconnect wires) and metal vias. The metal vias may include a lower via layer 134 and an upper via layer 138. The metal lines include an upper metal line 136 that is between the lower via layer 134 and the upper via layer 138 in the vertical direction Z. The lower via layer 134 may be on a lower interconnect 132, which may be a lower metal line or a lower contact.

An insulating material 140 may be on sidewalls of the upper via layer 138 and on an upper surface of the upper metal line 136. For example, the upper via layer 138 may comprise openings 148 therein, and the insulating material 140 may be in the openings 148. In some embodiments, an upper surface of the insulating material 140 may be (substantially) coplanar with an upper surface of the upper via layer 138. Moreover, the upper via layer 138 may comprise a photo key therein. According to some embodiments, the photo key may be a pattern/shape in the upper via layer 138 that is defined by, and/or may include, the openings 148. The insulating material 140 may comprise, as an example, an oxide.

The upper via layer 138 has a pattern that includes first through fifth metal portions 138a-138e that are spaced apart from each other in a horizontal direction X. The photo key of the upper via layer 138 can include one or more of the first through fifth metal portions 138a-138e. In some embodiments, the photo key includes the second through fourth metal portions 138b-138d, and the first and fifth metal portions 138a, 138e may each comprise an upper via. In other embodiments, the photo key includes each of the first through fifth metal portions 138a-138e. In further embodiments, the photo key includes more or fewer metal portions of the upper via layer 138, and/or metal portions having different shapes, spacings, or sizes, relative to the metal portions that are shown in FIG. 1B. Moreover, one or more upper vias may be provided by additional metal portions of the upper via layer 138 that are not shown in FIG. 1B.

The upper via layer 138 and the upper metal line 136 may comprise the same metal. For example, the upper via layer 138 and the upper metal line 136 may each comprise Ru. As another example, the upper via layer 138 and the upper metal line 136 may each comprise rhodium (Rh) or iridium (Ir), which, like Ru, have lower resistivities than copper (Cu), and thus can advantageously be used instead of Cu. In some embodiments, the upper via layer 138 and the photo key therein may be formed by patterning an upper portion of a metal layer that includes the upper metal line 136. A distance 150 between the upper surface of the upper via layer 138 and an upper reference point (indicated by an upper broken line) indicates an amount (e.g., a vertical thickness) of the metal layer that is removed/lost by (i.e., after) planarizing the metal layer. Advantageously, the distance 150 is less than the vertical thickness (e.g., a via height) of the upper portion of the metal layer before the planarization, and upper surfaces of different metal portions 138a-138e of the upper via layer 138 may be (substantially) coplanar with each other.

For simplicity of illustration, a boundary 152 is shown between the upper via layer 138 and the upper metal line 136. It will be understood, however, that as the upper via layer 138 and the upper metal line 136 may comprise the same metal, the boundary 152 may not be a visible/discernible interface. Rather, the upper via layer 138 and the upper metal line 136 may be provided by a single, continuous metal layer having no visible/discernible interface or separation between the upper via layer 138 and the upper metal line 136.

The lower via layer 134 may comprise a different metal from that of the upper via layer 138 and the upper metal line 136. For example, the lower via layer 134 may comprise Cu, and the upper via layer 138 and the upper metal line 136 may each comprise Ru. Moreover, the lower interconnect 132 may comprise a metal that is different from that of the lower via layer 134.

The lower via layer 134 can include first through fifth metal portions 134a-134e that are spaced apart from each other in the horizontal direction X. In some embodiments, the lower via layer 134 may be aligned with the upper via layer 138. For example, the first through fifth metal portions 138a-138e of the upper via layer 138 may overlap the first through fifth metal portions 134a-134e, respectively, of the lower via layer 134 in the vertical direction Z. The first through fifth metal portions 134a-134e, however, may have different widths in the horizontal direction X and/or different thicknesses in the vertical direction Z, compared with the first through fifth metal portions 138a-138e. As an example, the first through fifth metal portions 134a-134e may be narrower, in the horizontal direction X, than the first through fifth metal portions 138a-138e. According to some embodiments, the first metal portion 134a and the fifth metal portion 134e may be respective lower vias. Moreover, one or more lower vias may be provided by additional metal portions of the lower via layer 134 that are not shown in FIG. 1B.

The upper via layer 138 may be coupled to the lower via layer 134 by the upper metal line 136, and the upper metal line 136 may be coupled to the lower interconnect 132 by the lower via layer 134. In some embodiments, the lower interconnect 132 and the upper metal line 136 may each extend longitudinally (i.e., primarily) in the horizontal direction X, which may be perpendicular to the vertical direction Z and to another horizontal direction Y.

FIG. 1B shows four vertical levels, in the vertical direction Z, of the BEOL region 130. The lower interconnect 132 is at a low (e.g., lowest) level, the lower via layer 134 is at a first middle level, the upper metal line 136 is at both the first middle level and a second middle level, and the upper via layer 138 and the insulating material 140 are each at a high (e.g., highest) level. For example, the upper surface of the insulating material 140 may be (substantially) coplanar with the upper surface of the upper via layer 138.

According to some embodiments, a thin layer 162 may be between the lower interconnect 132 and the upper metal line 136, as well as between the lower via layer 134 and the upper metal line 136. The thin layer 162 may be on an upper surface of the lower interconnect 132 and on upper surfaces and sidewalls of the lower via layer 134. As a result, the thin layer 162 may contact a lower surface of the upper metal line 136. The thin layer 162 may be, for example, an insulating layer or a metal adhesion layer.

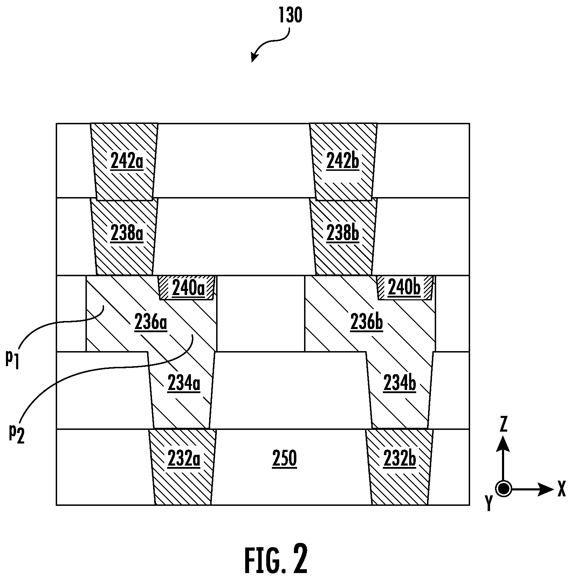

FIG. 2 is another example cross-sectional view of the BEOL region 130 of FIG. 1A. In some embodiments, this cross section may be taken along the horizontal direction X. In other embodiments, this cross section may be taken along the other horizontal direction Y. This cross section may thus be taken along the same horizontal direction as the cross section shown in FIG. 1B, or in a horizontal direction that is perpendicular to the horizontal direction of the cross section shown in FIG. 1B. Accordingly, the cross section shown in FIG. 2 may be in parallel with the cross section shown in FIG. 1B, or may be perpendicular to the cross section shown in FIG. 1B. Moreover, the cross section shown in FIG. 2 may be spaced apart from the cross section shown in FIG. 1B in the horizontal direction X or in the other horizontal direction Y.

As shown in FIG. 2, the BEOL region 130 may include one or more crack-stop wall structures. For example, the BEOL region 130 may include a first crack-stop wall structure that comprises a via-layer portion 234a and a metal-line-layer portion 236a that is on (e.g., vertically overlaps and is contiguous with) the via-layer portion 234a. A widest portion of the metal-line-layer portion 236a may be wider than (e.g., about twice as wide as) a widest portion of the via-layer portion 234a in the horizontal direction X. The BEOL region 130 may also include a second crack-stop wall structure that comprises a via-layer portion 234b and a metal-line-layer portion 236b that is on (e.g., vertically overlaps and is contiguous with) the via-layer portion 234b. The metal-line-layer portion 236a of the first crack-stop wall structure may comprise a first portion p₁ having a lower surface that is not in contact with the via-layer portion 234a. The metal-line-layer portion 236a may further include a second portion p₂ having a lower portion that is in contact/contiguous with the via-layer portion 234a and an upper surface having an oxide (or other insulating) region 240a thereon. The upper surface of the first portion p₁ may be (substantially) coplanar with an upper surface of the oxide region 240a.

According to some embodiments, the oxide region 240a may be in a recess (e.g., a recessed upper region) of the second portion p₂ of the metal-line-layer portion 236a of the first crack-stop wall structure. Similarly, the second crack-stop wall structure may have an oxide region 240b in a recess thereof. The second crack-stop wall structure may have the same (or similar) structure as that of the first crack-stop wall structure. For simplicity of illustration, however, the first and second portions p₁, p₂ are not labeled for the second crack-stop wall structure. In some embodiments, the oxide region 240a may comprise the same oxide material (e.g., silicon dioxide) as the oxide region 240b.

The first and second crack-stop wall structures may each comprise the same metal. For example, the metal-line-layer portion 236a and the via-layer portion 234a of the first crack-stop wall structure may each comprise Ru. Likewise, the metal-line-layer portion 236b and the via-layer portion 234b of the second crack-stop wall structure may each comprise Ru. The metal-line-layer portion 236a and the via-layer portion 234a may thus be provided by a single, continuous metal layer having no visible/discernible interface or separation therebetween. Likewise, the metal-line-layer portion 236b and the via-layer portion 234b may be provided by a single, continuous metal layer having no visible/discernible interface or separation therebetween.

The BEOL region 130 may include one or more layers above and below the crack-stop wall structures. As an example, the BEOL region 130 may include an upper via 238a that is in contact with the upper surface of the first portion p₁ of the metal-line-layer portion 236a of the first crack-stop wall structure. Because the oxide region 240a is on the upper surface of the second portion p₂ of the metal-line-layer portion 236a, the upper via 238 is not in contact with the upper surface of the second portion p₂. The BEOL region 130 may also include an upper via 238b that is in contact with an upper surface of the metal-line-layer portion 236b of the second crack-stop wall structure, without contacting the oxide region 240b.

An upper metal line 242a may be on an upper surface of the upper via 238a, and an upper metal line 242b may be on an upper surface of the upper via 238b. Moreover, a lower interconnect 232a may be on a lower surface of the via-layer portion 234a of the first crack-stop wall structure, and a lower interconnect 232b may be on a lower surface of the via-layer portion 234b of the second crack-stop wall structure. The lower interconnects 232a, 232b may be respective metal lines or respective contacts. In some embodiments, the lower interconnects 232a, 232b, the upper vias 238a, 238b, and the upper metal lines 242a, 242b may each comprise the same metal, which may be different from a metal of the first and second crack-stop wall structures.

FIG. 2 shows five vertical levels, in the vertical direction Z, of the BEOL region 130. The lower interconnects 232a, 232b are at a low (e.g., lowest) level, the first and second crack-stop wall structures are at the next two levels, and the upper vias 238a, 238b, and the upper metal lines 242a, 242b are at the two highest levels, respectively. A dielectric material 250 is at each of the five vertical levels. For example, the dielectric material 250 may electrically isolate the first and second crack-stop wall structures from each other. The dielectric material 250 may comprise a different insulating material from that of the oxide regions 240a, 240b. Moreover, an upper surface of the first crack-stop wall structure may be (substantially) coplanar with an upper surface of the second crack-stop wall structure. Likewise, a lower surface of the first crack-stop wall structure may be (substantially) coplanar with a lower surface of the second crack-stop wall structure.

The metal-line-layer portions 236a, 236b may, in some embodiments, have vertical sidewalls. The via-layer portions 234a, 234b, on the other hand, may have sloped/angled sidewalls. The metal-line-layer portions 236a, 236b and the via-layer portions 234a, 234b, however, are not limited to particular shapes, other than that upper surfaces of the metal-line-layer portions 236a, 236b must be sufficiently wide (i.e., wider than the via-layer portions 234a, 234b) to accommodate the upper vias 238a, 238b and the oxide regions 240a, 240b.

According to some embodiments, a method of forming the BEOL region 130 may include
depositing an oxide material of the oxide region 240a on the metal-line-layer portion 236a of the first crack-stop wall structure, and then planarizing the oxide material to provide the oxide region 240a. This planarization may include a selective CMP and/or an NSE. Moreover, as shown in FIG. 2, the oxide material (i.e., the oxide region 240a) remains on the upper surface of the second portion p₂ of the metal-line-layer portion 236a after planarizing the oxide material. The oxide region 240b may be formed on the metal-line-layer portion 236b in an analogous manner. In some embodiments, the oxide material of the oxide region 240a may be planarized concurrently with the oxide material of the oxide region 240b.

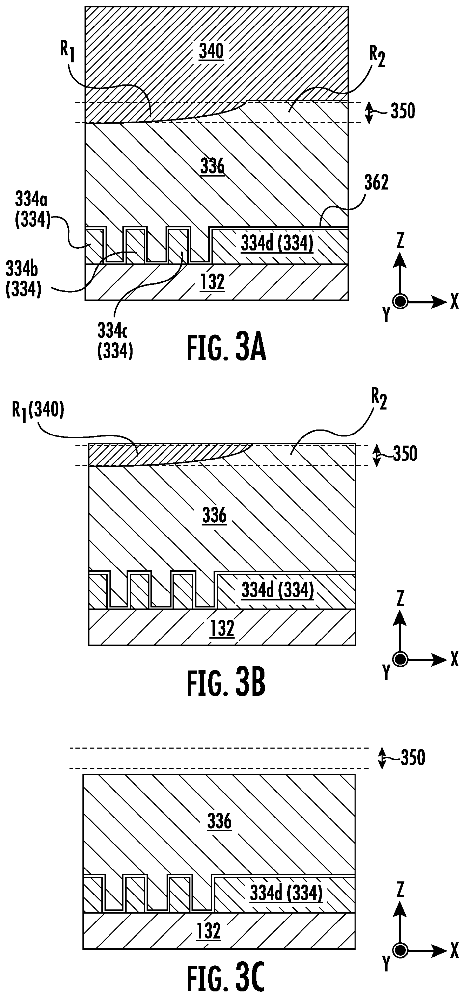

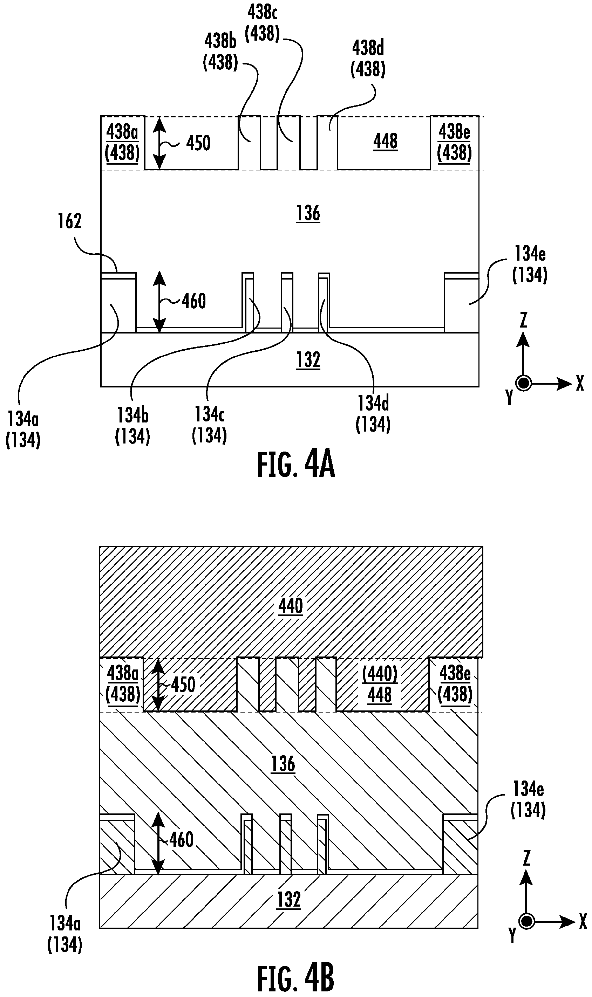

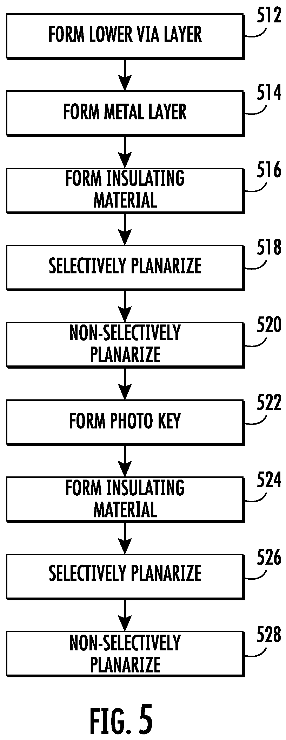

FIGs. 3A-3C and 4A-4C are cross-sectional views illustrating operations of forming a BEOL region 130 (FIG. 1A) according to some embodiments herein. FIG. 5 is a flowchart corresponding to the operations shown in FIGs. 3A-3C and 4A-4C.

As shown in FIGs. 3A and 5, the operations include forming (Block 512) a lower via layer 334 on a lower interconnect 132. In some embodiments, the lower via layer 334 may be patterned to include first through fourth metal portions 334a-334d. In other embodiments, the lower via layer 334 may be patterned to include more or fewer than four metal portions. One or more of the first through fourth metal portions 334a-334d may comprise a metal via.

According to some embodiments, a thin layer 362 may be formed on upper surfaces and sidewalls of the lower via layer 334, and on an upper surface of the lower interconnect 132. For example, the thin layer 362 may be an insulating liner that is conformally formed on the lower via layer 334. In some embodiments, the insulating liner may comprise nitride and may be formed by conformal nitride deposition. In other embodiments, the thin layer 362 may be a metal adhesion layer that is formed on the lower via layer 334. The metal adhesion layer may comprise a metal (e.g., aluminum (Al) or chromium (Cr)) that can improve adhesion of a metal layer to a dielectric layer. Moreover, the thin layer 362 may, in some embodiments, comprise the thin layer 162 (FIG. 1B), and thus may comprise the same insulating or metal material as the thin layer 162.

A metal layer 336 may be formed (Block 514) on the thin layer 362 (and thus on the lower via layer 334). Lower portions of the metal layer 336 may be between (i.e., in gaps between) the first through fourth metal portions 334a-334d in the horizontal direction X. In some embodiments, the fourth metal portion 334d may be wider than the first through third metal portions 334a-334c in the horizontal direction X. As a result, a first portion of an upper surface of the metal layer 336 that overlaps the fourth metal portion 334d in the vertical direction Z may be at a higher level, in the vertical direction Z, than a second portion of the upper surface of the metal layer 336 that overlaps the first through third metal portions 334a-334c in the vertical direction Z. The upper surface of the metal layer 336 may thus be an uneven (i.e., non-uniform) surface. For example, the upper surface of the metal layer 336 may slope/curve downward from the first portion to the second portion, due to the lower portions of the metal layer 336 that are between the first through fourth metal portions 334a-334d. A distance 350, in the vertical direction Z, indicates a difference between a vertical level of a highest portion of the upper surface of the metal layer 336 and a vertical level of a lowest portion of the upper surface of the metal layer 336.

Referring still to FIGs. 3A and 5, an insulating material 340 may be formed (Block 516) on the uneven upper surface of the metal layer 336. The insulating material 340 may comprise, for example, an oxide. A lower portion of the insulating material 340 is on the second portion of the upper surface of the metal layer 336 that overlaps the first through third metal portions 334a-334c. This lower portion of the insulating material 340 is indicated by a first region R₁ in FIG. 3A, which is a recess in the metal layer 336. A second region R₂ that is beside the first region R₁ in the horizontal direction X is provided by an upper portion of the metal layer 336 (including the first portion of the upper surface of the metal layer 336 that overlaps the fourth metal portion 334d). The first and second regions R₁, R₂ are both within the distance 350. An upper portion of the insulating material 340 is above (i.e., overlaps) the first and second regions R₁, R₂ in the vertical direction Z.

Referring to FIGs. 3B and 5, the upper portion of the insulating material 340 is removed. As an example, the insulating material 340 may be selectively planarized (Block 518), such as by a selective CMP that targets the insulating material 340. For example, the insulating material 340 may comprise an oxide, and the CMP may be an oxide CMP that targets (i.e., selectively removes) the oxide. The metal layer 336 may serve as a stop for the selective planarization. As a result, the insulating material 340 may remain in the first region R₁ (e.g., on a sloped portion of the upper surface of the metal layer 336) while a flat portion of the upper surface of the metal layer 336 that is in the second region R₂ is exposed. An upper surface of the insulating material 340 may thus be (substantially) coplanar with the exposed portion of the upper surface of the metal layer 336.

Referring to FIGs. 3C and 5, an NSE (i.e., a non-selective planarization) may be performed (Block 520) on the insulating material 340 (FIG. 3B) and the metal layer 336, after the selective planarization. The NSE may remove the insulating material 340 from the first region R₁ and may remove the metal layer 336 from the second region R₂. As a result, the upper surface of the metal layer 336 may be uniform (i.e., flat), and the distance 350 may indicate a vertical thickness of the metal layer 336 that is lost (i.e., removed) by the NSE. The entirety of the upper surface of the metal layer 336 may be exposed after the NSE.

As shown in FIGs. 4A and 5, a photo key may be formed (Block 522) in an upper portion of a metal (e.g., Ru) layer. In some embodiments, the metal layer may be the metal layer 336 after the planarization that is shown in FIG. 3C. The photo key may thus be formed in an upper portion of the metal layer 336 after the planarization (e.g., the NSE) that is shown in FIG. 3C. In other embodiments, the photo key may be formed in the metal layer without first performing the planarizations that are shown in FIGs. 3B and 3C. The operations of Blocks 516-520 of FIG. 5 may thus be omitted.

Forming the photo key may include patterning the upper portion of the metal layer to provide an upper via layer 438 that includes first through fifth metal portions 438a-438e that are spaced apart from each other in the horizontal direction X. A lower portion of the metal layer comprises an upper metal line 136. The first through fifth metal portions 438a-438e may be protruding portions of the metal layer that protrude upward, in the vertical direction Z, from the upper metal line 136. As the upper via layer 438 and the upper metal line 136 are upper and lower portions, respectively, of the same metal layer (e.g., the metal layer 336), the upper via layer 438 and the upper metal line 136 each include the same metal (e.g., Ru). An upper distance 450 indicates a vertical thickness of the upper via layer 438 in the vertical direction Z. The upper distance 450 may be equal to, or similar to, a lower distance 460 that indicates a vertical thickness of a lower via layer 134 in the vertical direction Z. The distances 450, 460 may also each be referred to herein as a "via height." One or more metal portions of the upper via layer 438 may overlap one or more portions of the lower via layer 134 in the vertical direction Z.

Openings 448 are between the first through fifth metal portions 438a-438e in the horizontal direction X. In some embodiments, the first through fifth metal portions 438a-438e are each part of the photo key. In other embodiments, one or more of the first through fifth metal portions 438a-438e may be metal vias. As an example, the first metal portion 438a and the fifth metal portion 438e, which may be wider than the second through fourth metal portions 438b-438d in the horizontal direction X, may be metal vias.

As shown in FIGs. 4B and 5, an insulating material 440 may be formed (Block 524) on the photo key. A lower portion of the insulating material 440 is formed in the openings 448 between the first through fifth metal portions 438a-438e. An upper portion of the insulating material 440 may be formed on upper surfaces of the first through fifth metal portions 438a-438e and on the lower portion of the insulating material 440.

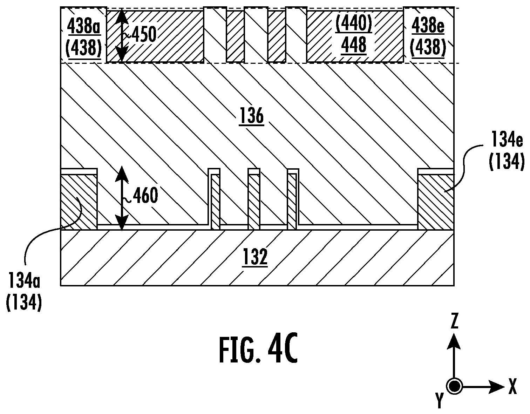

Referring to FIGs. 4C and 5, the insulating material 440 may be planarized, such as by a selective planarization (Block 526) that targets the insulating material 440. As an example, the insulating material 440 may include an oxide material, and a selective CMP (e.g., an oxide CMP) may be performed that targets the oxide material. The upper via layer 438 may serve as a stop for the selective planarization. As a result of selectively planarizing the insulating material, an upper surface of the insulating material 440 may be (substantially) coplanar with the upper surfaces of the first through fifth metal portions 438a-438e. After the selective planarization, the insulating material 440 and the upper via layer 438 may both have a vertical thickness that is equal to, or similar to, the upper distance 450 in the vertical direction Z. Accordingly, the selective planarization may not cause the upper via layer 438 to decrease in height in the vertical direction Z, or may cause only a negligible decrease in height for the upper via layer 438.

As shown in FIGs. 1B and 5, the insulating material 440 (FIG. 4C) may be further planarized, such as by an NSE (Block 528), or another non-selective planarization, that reduces vertical thicknesses (and thus heights) of both the upper via layer 438 (FIG. 4C) and the insulating material 440 in the vertical direction Z, without (i.e., instead of) selectively targeting the insulating material 440 relative to the upper via layer 438. This results in a planarized upper via layer 138 that is vertically thinner than the upper via layer 438, as well as a planarized insulating material 140 that is vertically thinner than the insulating material 440. A distance 150 indicates a vertical thickness (in the vertical direction Z) of the upper via layer 438 (and the insulating material 440) that is removed/lost during the non-selective planarization that results in the thinner, planarized upper via layer 138 and the thinner, planarized insulating material 140. First through fifth metal portions 138a-138e of the upper via layer 138 correspond to (i.e., result from vertically thinning) the first through fifth metal portions 438a-438e (FIG. 4C), respectively. The insulating material 140 is in openings 148 that are between the first through fifth metal portions 138a-138e in the horizontal direction X.

The terms "planarizing" and "planarization," as used herein, may broadly refer to selective and/or non-selective planarization. Accordingly, the terms "planarizing" and "planarization" may refer to operations shown in Blocks 526 and/or 528 (and/or Blocks 518 and/or 520). Similarly, the phrase "reducing the height of the insulating material and the photo key" may refer to the operations shown in Blocks 526 and/or 528 (and/or Blocks 518 and/or 520).

One or more of the first through fifth metal portions 138a-138e may provide a photo key, which is vertically thinner than the photo key that is illustrated in FIGs. 4A-4C. The insulating material 140 (e.g., an oxide) is in the photo key after planarizing the insulating material 440 and the upper via layer 438. The insulating material 440 and the upper via layer 438 may therefore be referred to herein as a "preliminary insulating region" and a "preliminary upper via layer" (or a "preliminary photo key"), respectively, that precede (and provide the basis for) the insulating material 140 and the upper via layer 138, respectively. The photo key shown in FIG. 1B is formed by reducing a height (i.e., a vertical level/thickness) of the preliminary photo key shown in FIGs. 4A-4C.

Though the lower via layer 334 (FIGs. 3A-3C) is shown as having a shape/pattern different from that of the lower via layer 134 (FIGs. 4A-4C and 1B), the lower via layers 134, 334 may, in some embodiments, have the same shape/pattern and/or may be the same portion/layer of the BEOL region 130 (FIG. 1B). The operations shown in FIGs 4A-4C and 1B may thus be performed on the planarized structure that is shown in FIG. 3C. In other embodiments, the operations shown in FIGs 4A-4C and 1B may be performed independently (concurrently) of (e.g., without first performing) the operations shown in FIGs. 3A-3C. Moreover, the lower via layer 334 and the lower via layer 134 may be in different (e.g., spaced-apart) portions of the BEOL region 130.

According to some embodiments, the oxide regions 240a, 240b (FIG. 2) may be formed and planarized by, and/or concurrently with, operations of forming and planarizing the insulating material 340 (FIGs. 3A-3C) and/or the insulating material 440 (FIGs. 4A-4C). For example, the oxide regions 240a, 240b may be part of the insulating material 340 or the insulating material 440. The oxide regions 240a, 240b may thus be formed and planarized by operations shown in FIG. 5. In other embodiments, the oxide regions 240a, 240b may be formed and planarized independently of (e.g., separately from) the operations shown in FIG. 5.

In some embodiments, a dielectric material 250 (FIG. 2), which may be on upper and side surfaces of the oxide regions 240a, 240b, may be formed by performing a low-k material fill on the metal portions of the structure shown in FIG. 2. As used herein, the term "low-k" refers to a material that has a smaller dielectric constant than silicon dioxide. The low-k material may include, for example, fluorine-doped silicon dioxide, organosilicate glass, carbon-doped oxide, porous silicon dioxide, porous organosilicate glass, a spin-on organic polymeric dielectric, or a spin-on silicon based polymeric dielectric. According to some embodiments, the dielectric material 250 may be formed by inter-metal dielectric (IMD) fill, followed by planarization (e.g., CMP).

Methods of forming a BEOL region 130 (FIG. 1A) of an IC device 100 (FIG. 1A) according to embodiments herein may provide a number of advantages. These advantages include good (e.g., more accurate) sublayer photo-key readability at the surface of a metal (e.g., Ru) layer. This improvement in reading photo-key information may be facilitated by increased uniformity in the vertical thickness of an upper via layer 138 (FIG. 1B) that comprises a photo key. In contrast, conventional planarization techniques, such as an Ru buffing CMP, may result in more variation in the vertical thickness of an upper via layer. Moreover, because the photo key has an insulating material 140 (FIG. 1B) therein (e.g., between, in the horizontal direction X, metal portions 138a-138e (FIG. 1B) of the upper via layer 138) that has been planarized with good local topology, sublayer information can be read relatively easily in the surface of upper via layer 138 (e.g., in an upper surface of an Ru layer). Conventional metal planarization techniques, by contrast, may lack deposition and planarization of an insulating material (e.g., in a photo key).

Another advantage may be planarization of the metal layer with only small/minimal loss of the metal layer. In contrast, conventional planarization techniques may result in the loss of a vertical thickness of the metal layer that extends beyond (i.e., lower than a lowermost level of) a via height of the upper via layer.

Example embodiments are described herein with reference to the accompanying drawings. Many different forms and embodiments are possible without deviating from the teachings of this disclosure and so the disclosure should not be construed as limited to the example embodiments set forth herein. Rather, these example embodiments are provided so that this disclosure will be thorough and complete, and will convey the scope of the present invention to those skilled in the art. In the drawings, the sizes and relative sizes of layers and regions may be exaggerated for clarity. Like reference numbers refer to like elements throughout.

Example embodiments are described herein with reference to cross-sectional illustrations that are schematic illustrations of idealized embodiments and intermediate structures of example embodiments. As such, variations from the shapes of the illustrations as a result, for example, of manufacturing techniques and/or tolerances, are to be expected. Thus, embodiments herein should not be construed as limited to the particular shapes illustrated herein but may include deviations in shapes that result, for example, from manufacturing.

It should also be noted that in some alternate implementations, the functions/acts noted in flowchart blocks herein may occur out of the order noted in the flowcharts. For example, two blocks shown in succession may in fact be executed substantially concurrently or the blocks may sometimes be executed in the reverse order, depending upon the functionality/acts involved. Moreover, the functionality of a given block of the flowcharts and/or block diagrams may be separated into multiple blocks and/or the functionality of two or more blocks of the flowcharts and/or block diagrams may be at least partially integrated. Finally, other blocks may be added/inserted between the blocks that are illustrated, and/or blocks/operations may be omitted without departing from the scope of the present invention.

Unless otherwise defined, all terms (including technical and scientific terms) used herein have the same meaning as commonly understood by one of ordinary skill in the art to which this disclosure belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

The terminology used herein is for the purpose of describing particular embodiments only and is not intended to be limiting of the disclosure. As used herein, the singular forms "a," "an," and "the" are intended to include the plural forms as well, unless the context clearly indicates otherwise. It will be further understood that the terms "comprises," "comprising," "includes," and/or "including," when used in this specification, specify the presence of the stated features, steps, operations, elements, and/or components, but do not preclude the presence or addition of one or more other features, steps, operations, elements, components, and/or groups thereof.

It will be understood that when an element is referred to as being "coupled," "connected," or "responsive" to, or "on," another element, it can be directly coupled, connected, or responsive to, or on, the other element, or intervening elements may also be present. In contrast, when an element is referred to as being "directly coupled," "directly connected," or "directly responsive" to, or "directly on," another element, there are no intervening elements present. As used herein, the term "and/or" includes any and all combinations of one or more of the associated listed items. Moreover, the symbol "/" (e.g., when used in the term "source/drain") will be understood to be equivalent to the term "and/or."

It will be understood that although the terms "first," "second," etc. may be used herein to describe various elements, these elements should not be limited by these terms. These terms are only used to distinguish one element from another. Thus, a first element could be termed a second element without departing from the teachings of the present embodiments.

Spatially relative terms, such as "beneath," "below," "lower," "above," "upper," and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if a device in the figures is turned over, elements described as "below" or "beneath" other elements or features would then be oriented "above" the other elements or features. Thus, the term "below" can encompass both an orientation of above and below. The device may be otherwise oriented (e.g., rotated 90 degrees or at other orientations) and the spatially relative descriptors used herein may be interpreted accordingly.

Many different embodiments have been disclosed herein, in connection with the above description and the drawings. It will be understood that it would be unduly repetitious and obfuscating to literally describe and illustrate every combination and subcombination of these embodiments. Accordingly, the present specification, including the drawings, shall be construed to constitute a complete written description of all combinations and subcombinations of the embodiments described herein, and of the manner and process of making and using them, and shall support claims to any such combination or subcombination.

## Claims

1. A method of forming a back-end-of-line, BEOL, region (130) of an integrated circuit device (100), the method comprising:
forming (514) a metal layer (336) on a lower via (134);
forming (522) a photo key in an upper portion of the metal layer (336);
forming (524) an insulating material (440) on the photo key; and
planarizing (526, 528) the insulating material (440) and the metal layer (336) that includes the photo key.

2. The method of Claim 1, wherein the planarizing (526, 528) comprises performing (526) chemical-mechanical planarization, CMP, of the insulating material (440).

3. The method of Claim 2,
wherein the CMP comprises selective CMP that selectively removes the insulating material (440), or
wherein the insulating material (440) comprises an oxide the CMP comprises an oxide CMP that selectively removes the oxide.

4. The method of Claim 2 or 3, wherein the planarizing (526, 528) comprises performing (528) a non-selective dry etch, NSE, of the insulating material (440), after performing the CMP.

5. The method of Claim 4, wherein the NSE reduces a height of the photo key.

6. The method of any one of Claims 1 to 5,
wherein the lower via (134) comprises a first metal, and
wherein the metal layer (336) comprises a second metal that is different from the first metal.

7. The method of Claim 6, wherein the second metal comprises ruthenium.

8. The method of any one of Claims 1 to 7,
wherein the photo key comprises an opening in an upper via layer (138),
wherein the upper via layer (138) is aligned with the lower via (134),
wherein the insulating material (440) is in the opening, and
wherein an upper surface of the insulating material (440) is coplanar with an upper surface of the upper via layer (138), after the planarizing.

9. The method of any one of Claims 1 to 8, further comprising planarizing the metal layer (336) before forming the photo key.

10. The method of Claim 9, wherein planarizing the metal layer (336) before forming the photo key comprises:
depositing (516) an oxide material on an upper surface of the metal layer (336);
performing (518) a selective chemical-mechanical planarization, CMP, of the oxide material, thereby exposing a first portion of the upper surface of the metal layer (336) while the oxide material remains on a second, sloped portion of the upper surface of the metal layer (336); and
performing (520) a non-selective dry etch, NSE, of the insulating material (440), after performing the selective CMP, thereby removing the oxide material from the second, sloped portion of the upper surface of the metal layer (336) and reducing a height of the first portion of the upper surface of the metal layer (336).

11. The method of any one of Claims 1 to 10, wherein the BEOL region (130) comprises a crack-stop wall structure comprising:
a via-layer portion (234a, 234b); and
a metal-line-layer portion (236a, 236b) on the via-layer portion (234a, 234b), the metal-line-layer portion (236a, 236b) comprising:
a first portion (P1) having a lower surface that is not in contact with the via-layer portion (234a, 234b); and
a second portion (P2) having a lower portion that is in contact with the via-layer portion (234a, 234b) and an upper surface having an oxide material thereon.

12. The method of Claim 11, wherein the oxide material is in a recess of the second portion (P2) of the metal-line-layer portion (236a, 236b) of the crack-stop wall structure.

13. The method of Claim 11 or 12, wherein the BEOL region (130) further comprises a via (238a, 238b) that is in contact with an upper surface of the first portion (P1) of the metal-line-layer portion (236a, 236b) of the crack-stop wall structure.

14. The method of any one of Claims 11 to 13, further comprising:
depositing the oxide material on the metal-line-layer portion (236a, 236b) of the crack-stop wall structure; and
planarizing the oxide material,
wherein the oxide material remains on the upper surface of the second portion (P2) of the metal-line-layer portion (236a, 236b) of the crack-stop wall structure after planarizing the oxide material.

15. The method of any one of Claims 1 to 14, wherein forming the photo key comprises patterning the metal layer (336).
